# EUROPEAN PATENT SPECIFICATION

(11) **EP 0 643 451 B1**
(45) Date of publication and mention of the grant of the patent: **21.06.2000**
(21) Application number: 94306728.0
(22) Date of filing: 14.09.1994
(51) Int. Cl.: H01R 12/20

(54) **Electrical connector**
Elektrischer Verbinder
Connecteur électrique

(30) Priority: 14.09.1993 US 121210
(43) Date of publication of application: 15.03.1995
(60) Divisional application: 99124525.9
(73) Proprietor: BERG ELECTRONICS MANUFACTURING B.V., 5222 AV's-Hertogenbosch (NL)
(72) Inventor: Yu, Wang-I, TW-Chung-Ho, Taipei Hsien (TW)
(74) Representative: Barnard, Eric Edward

(56) References cited:
- US-A- 4 986 765
- US-A- 4 995 825
- US-A- 5 112 242
- US-A- 5 169 333

## Description

### FIELD OF THE INVENTION

The present invention relates to an electrical connector for connecting together two circuit boards and to a latching arrangement for use in such a connector.

### BACKGROUND OF THE INVENTION

An electrical connector is a device which electrically and mechanically connects, for example, a memory board called a "mother board" to a daughter board such as a single-in-line memory module (SIMM). A conventional electrical connector comprises a housing to be mounted on a mother board and one pair of metal latch members. Each latch member may be inserted into a latch receiving member provided near one end of the housing for holding a daughter board. The housing has a slot for receiving a base end of the daughter board. Contact terminals are provided in the slot to enable electrical connection between the mother and daughter boards.

The daughter board which is inserted into the slot is rotated along an axis of the slot between the paired metal latch members. When the side edges of the daughter board come into contact with the metal latch members, the paired metal latch members can be elastically flexed away from each other. The daughter board reaches a predetermined position, and the paired metal latch members elastically return to their initial positions. Thus, the daughter board is held in a sandwiched relation. However, the fixing of the metal latch members is by way of "insertion". After repeated attaching and detaching of the daughter board, the metal latch members may become loose and lose stability and the clamping force against the daughter board suffers. Examples of such connectors are the subject of issued patents US-A-4 986 765, US-A-5 112 242, US-A-4 995 825 and US-A-5 169 333. In US-A-4 986 765 the connector is provided with latch members manufactured from a material having appropriate resilience and strength characteristics and to a design suitable for tolerating a wider range of daughter board widths. The latch members may also be used to establish electrical connection with the daughter board.

Furthermore, the latch receiving members must be complex and large enough to receive the insertion of the metal latch members. More material may be needed due to a larger outer configuration of the housing. It may not be easy to mold a housing of such a complex configuration. As a result, the electrical connector is complex and expensive to manufacture.

### SUMMARY OF THE INVENTION

Due to the drawbacks discussed above, one of the objects of this invention is to provide an electrical connector that is simpler and easier to manufacture at a low cost. It is another object to ensure high durability of metal fasteners and enhance the reliability with which the daughter board can be electrically connected to contact terminals even after repeated attachment and detachment of a daughter board.

In accordance with the present invention there is provided an electrical connector for connecting together first and second circuit boards, said connector comprising:
a housing formed from an insulating material, said housing serving to locate the first and second circuit boards for connection and having a top surface in which there is a longitudinal groove for receiving the second circuit board therein;
a latch member engageable with the second circuit board, said latch member extending from the top surface of the housing and being positioned near an end portion of the housing, said latch member having a rib projecting along an edge thereof;
a plurality of contact terminals provided in the groove of the housing for connecting together the first and second circuit boards and
a fastener or latch attached to the housing adjacent to the latch member and including a fixing or mounting section and a spring section, said fastener being mounted with the mounting section of the latch attached to the associated end portion of the housing and the spring section of the latch being placed in elastic contact with the adjacent latch member wherein the spring section of the latch is provided with a slot
   characterised in that
the rib of the latch member extends through the slot to an extent that the rib guides the spring section of the fastener and inhibits side shifting of the fastener and rotation of the fastener.

The connector may further comprise a further latch member positioned near another end portion of the housing and a further fastener or latch attached to the housing adjacent to the further latch member and associated therewith, the mounting section of the further fastener or latch being attached to said other end of portion of the housing.

In one arrangement the mounting section of the or each fastener or latch may have two side plates, each side plate being provided with a pair of mounting legs located at lower corners thereof, whereby the latch is fixed firmly by clamping the mounting legs in corresponding recesses or indentations provided at a side of the associated end portion of the housing. In another arrangement the mounting section of the or each fastener or latch may have two side plates, at least one of the side plates having an opening therein and wherein the associated end portion of the housing has a corresponding projection which engages in the opening.

Preferably, the slot in the or each fastener or latch and the associated rib of the associated latch member closely fit together to prevent the side shifting of the latch.

The or each fastener or latch may be provided with an anti-overstress member for preventing the fastener or latch from being overstressed. The member can be joined by a partially punched out portion of the associated fastener or latch, and in this case the punched out portion may correspond to the slot of the associated fastener or latch. The anti-overstress member may be integrated with the associated fastener or latch. The anti-overstress member can be in the form of a restricting leg adjacent the slot of the associated fastener or latch; the leg extending in a plane substantially perpendicular to the spring section and being spaced from the mounting section.

The or each latch member may be provided with a boss at one side near the groove of the housing for location with the second circuit board.

Other aspects, advantages and features of the present invention may be more fully understood and appreciated by reference to the following description. with the end portion of the housing firmly to ensure the stability.

Alternatively the fixing section has openings in side plates thereof. The corresponding sides of the end portion of the housing are then provided with a projection. The openings of the metal fastener then engage the projections of the housing to ensure the stability.

In another aspect, the present invention provides an electrical connector for connecting a first circuit board to a second circuit board, said connector comprising:
a connector housing for electrically and structurally connecting the first circuit board to the second circuit board, said connector housing having an outer surface and a groove formed in the outer surface for accepting one of the circuit boards;
a separate latch located adjacently to one end of said groove for resiliently engaging the one circuit board so as to maintain the circuit board at a predetermined angle and a predetermined position with respect to the other circuit board when the one circuit board is placed in said groove of said connector housing;
a rib located on said outer surface adjacent to the groove for engaging the latch to prevent the latch from rotating; and
an anchoring member located adjacent to said latch for anchoring said latch to said connector housing, said anchoring member being formed to conform to a predetermined portion of said outer surface of said connector housing.

In a further aspect, the present invention provides an electrical connector for connecting a first circuit board to a second circuit board, said connector comprising:
a connector housing for electrically and structurally connecting the first circuit board to the second circuit board, said connector housing having a groove for accepting one of the circuit boards;
a separate latch located adjacently to one end of said groove for resiliently engaging the one circuit board so as to maintain the one circuit board at a predetermined angle and a predetermined position with respect to the other circuit board when the one circuit board is placed in said groove of said connector housing; and
an anti-rotational member located adjacent to said latch and to said groove for further preventing said latch from rotating so as to maintain the one circuit board at said predetermined angle with respect to the other circuit board.

In another aspect, the present invention provides an electrical connector for connecting a first circuit board to a second circuit board, said connector comprising:
a connector housing for electrically and structurally connecting the first circuit board to the second circuit board, said connector housing having a groove for accepting one of the circuit boards;
a rib located adjacent to one end of said groove for providing a projection transverse to a longitudinal axis of said groove;
a separate latch located adjacent to said rib for resiliently engaging an edge of the one circuit board so as to maintain the one circuit board at a predetermined angle and a predetermined position with respect to the other circuit board when the one circuit board is placed in said groove of said connector housing, said latch having a slot, said rib tightly fitting said slot for further maintaining said predetermined angle, a portion of said latch which is partially detached by punching said portion to define an anti-overstress member for preventing the latch from being over-stressed, said latch also having a hook; and
a structure for anchoring said latch to said connector housing.

In a further aspect, the present invention provides a latching arrangement in a board-to-board connector for latching a first circuit board at a predetermined angle with respect to the second circuit board, said latching arrangement comprising:
a separate latch for resiliently latching the first circuit board, said separate latch having a punched slot and resiliently flexing away from the first circuit board during an installation and a removal of the first circuit board;
a rib located adjacent to the first circuit board and extending through said punched slot for guiding said separate latch during said installation and said removal; and
an anti-overstress member located near said punched slot for preventing said separate latch from being over-stressed during said installation and said removal.

In another aspect, the present invention provides a latching arrangement for a board-to-board connector for latching a first circuit board at a predetermined angle with respect to the second circuit board, said latching arrangement comprising:
a separate latch for resiliently latching the first circuit board and having a punched slot, said separate latch resiliently flexing away from the first circuit board during an installation and a removal of the first circuit board;
an anti-rotational member located adjacent to the first circuit board and extending through said punched slot for guiding said separate latch and for preventing undesirable rotation of said separate latch during said installation and said removal; and
an anti-overstress member integral with said separate latch and provided by a partially punched-out portion which corresponds to said punched slot of said separate latch for preventing said separate latch from being over-stressed during said installation and said removal.

Other aspects, advantages and features of the present invention may be more fully understood and appreciated by reference to the following description.

### BRIEF DESCRIPTION OF THE DRAWINGS

Figure 1 is a perspective view of a first embodiment of a connector and latching arrangement in accordance with the invention:
Figure 2 is a partially enlarged fragmentary view of the first embodiment, wherein contact terminals are omitted for simplification;
Figure 3 is a partially enlarged fragmentary view of the first embodiment, wherein contact terminals are omitted for simplification;
Figure 4 is a sectional view taken substantially along the line 4-4 of Figure 1;
Figure 5 is a partially enlarged fragmentary view of a second embodiment of a connector and latching arrangement wherein contact terminals are omitted for simplification; and
Figure 6 is a partially enlarged fragmentary view of the second embodiment, wherein contact terminals are omitted for simplification.

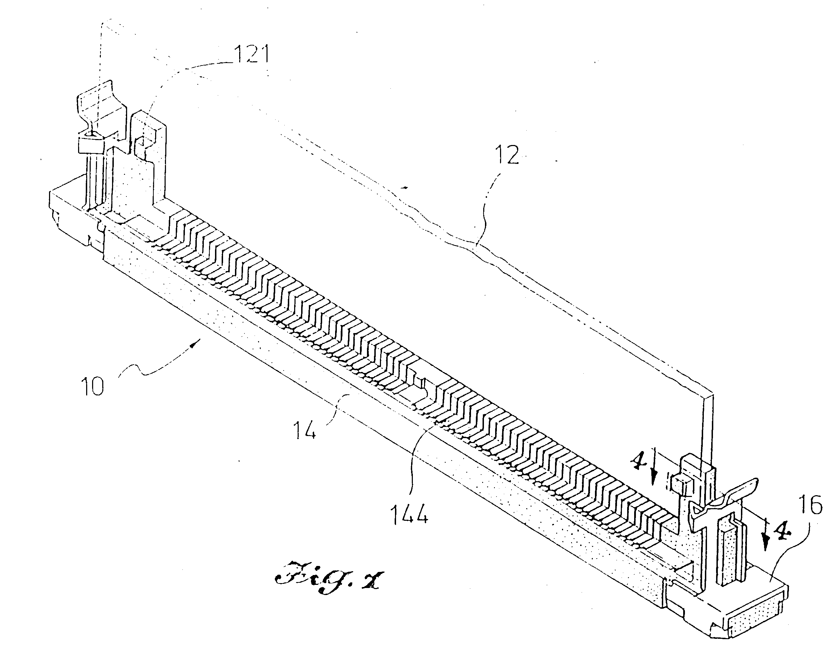

Referring now to Figures 1 through 3, an electrical connector 10 in accordance with the present invention mechanically and electrically connects a mother board (not shown) and a daughter board 12, which is inserted into the electrical connector 10. For example, the mother board is a memory control board while the daughter board is a single-in-line memory module (SIMM) on which a memory chip is mounted (not shown).

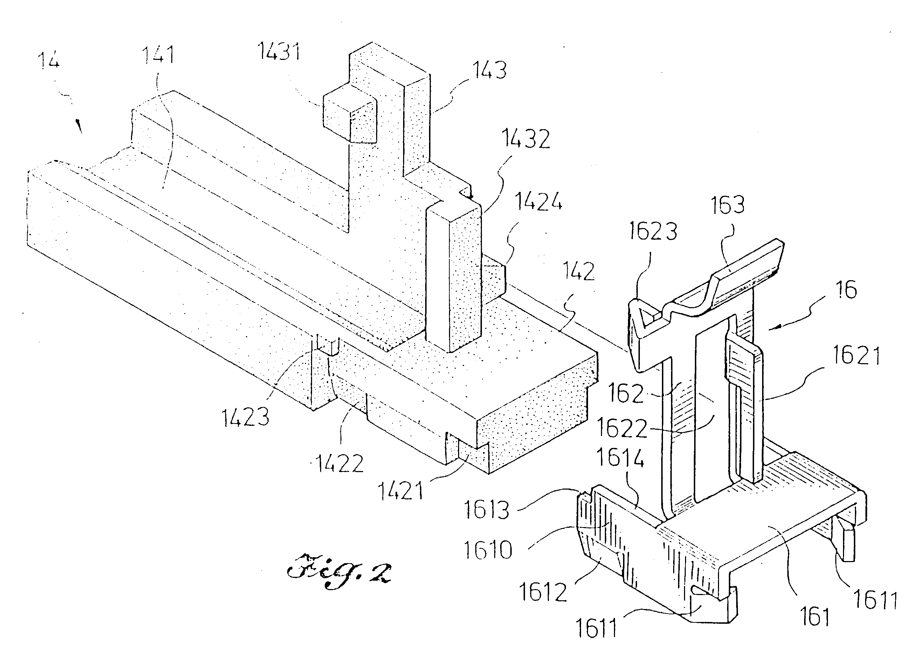

Referring to Figure 2, the electrical connector 10 comprises an elongated connector housing 14 molded of an insulating resin material with two ends portions 142. A groove 141 is provided longitudinally on the top surface of the housing 14 between the two end portions 142 for receiving the daughter board 12. A plurality of contact terminals 144 are arranged in the groove 141 of the housing 14 as shown in Figure 1 to enable electrical connector between the mother board and the daughter board.

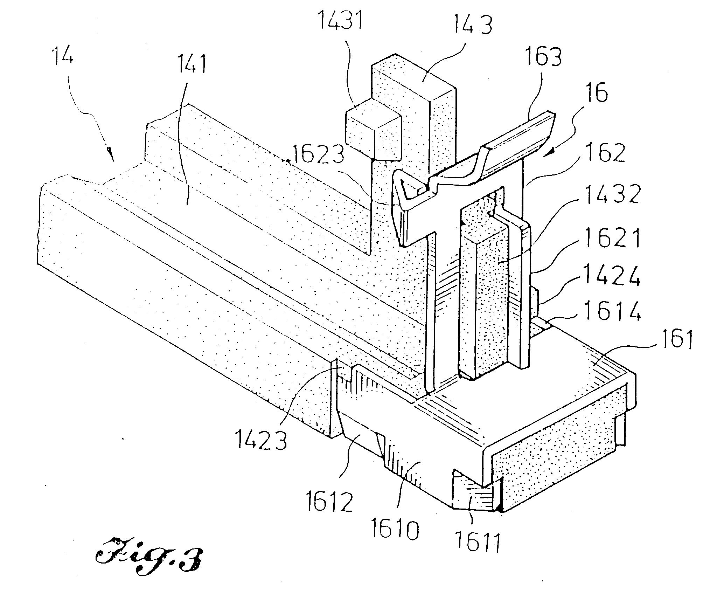

Referring to Figures 2 and 3, a pair of projections forming latch members 143 made of the resin material are integrally molded with the housing 14 and uprightly located adjacent to the end portions 142 of the housing 14. A rib or anti-rotational member 1432 is provided on each end portion 142 and more particularly on the latch member 143. The side of each latch member 143, near to the groove 141 of the housing 14 is provided with a boss 1431. The other side of the latch member 143 is provided with a first tab 1424. When the bottom edge of the daughter board 12 is inserted into the groove 141 of the housing 14, the boss 1431 engages with the corresponding daughter board's opening 121 as shown in Figure 1.

Still referring to Figures 2 and 3, a pair of separable metal fasteners or latches 16 are detachably clamped on the end portions 142 of the housing 14. Each metal fastener 16 comprises a fixing section 161 and a spring section 162 substantially extending therefrom. The fixing section 161 has two side plates 1610. Each side plate 1610 is provided with a pair of bendable mounting legs, hooks or anchoring members 1611 and 1612 separated by a space at the lower corners. The metal fastener 16 is fixed firmly by clamping the mounting legs 1611 and 1612 on a corresponding recess 1421 and slanting cut or catch 1422 provided at the bottom side of the end portion 142 of the housing 14. Further, a notch 1613 is formed at the corner of one of side plates 1610 of the fixing section 161 to engage a second tab 1423 provided at the side of the housing 14 opposite to the first tab 1424. The top edge of the other side plate 1610 resists against the bottom edge of the first tab 1424 of the latch member 143. Thus, the metal fastener 16 can resist the force exerted from varied directions and ensures its stability.

Still referring to Figures 2 and 3, the spring section 162 of the metal fastener 16 is flexible and a restriction leg or anti-overstress member 1621 and a slot or anti-rotational member 1622 are formed by punching the spring section 162. The restricting leg 1621 is substantially vertical to the surface of the spring section 162 and has a suitable clearance with the fixing section 161 such that it regulates any excessive flexing of the spring section 162 to avoid possible overstress. When the metal fastener 16 clamps on the housing 14, the rib 1432 of the latch member 143 exactly fits the slot 1622 so as to prevent the side shifting of the metal fastener 16.

A handle 163 is preferably provided on the upper end of the sprang section 162 and extends such that it can be manually moved to flex the spring section 162 during attachment and detachment of the daughter board 12 to and from the housing 14. A lug 1623 is provided on the upper end of one edge of the spring section 162 such that it contacts the surface of the daughter board 12 to provide an auxiliary holding effect relative to the daughter board 12.

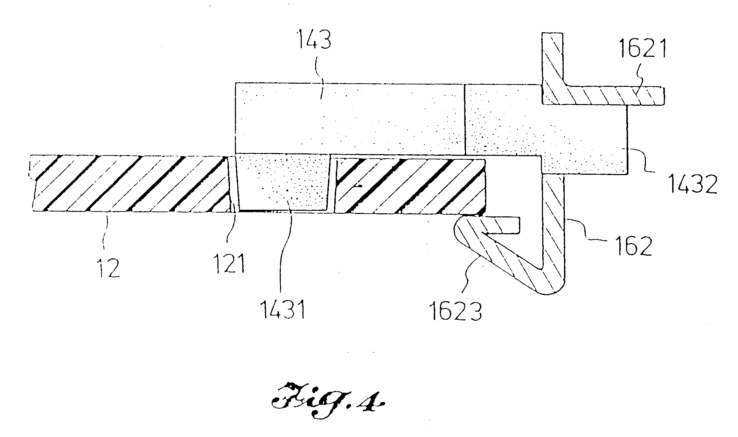

With reference to Figure 4, upon the attachment of the daughter board 12 to the electrical connector 14, the base end portion of the daughter board 12 is initially inserted into the groove 141 in an oblique direction to the mother board. Then the daughter board 12 is partly rotated or swivelled toward the latch member 143. During the swivelling process, the side edges of the daughter board 12 will slide on the slanting surface of the lug 1623 of each metal fastener 16 and the spring sections 162 are pushed out. When the base end of the daughter board 12 is vertically placed on the housing 14, the bosses 1431 of the latch members 143 are fitted in the associated openings 121 the daughter board 12. At the same time, the spring sections 162 elastically return to their initial position and hold the side edges of the daughter board 12 in a sandwiched relation. Upon the detachment of the daughter board 12 from the electrical connector 14, the spring sections 162 of the metal fasteners 16 are expanded so as to move away from each other. This can be readily done by operating the handles 163 of the metal fasteners 16. This operation unlatches the daughter board 12 from the paired metal fasteners 16. Then, the unlatched daughter board 12 can be removed from the electrical connector 14.

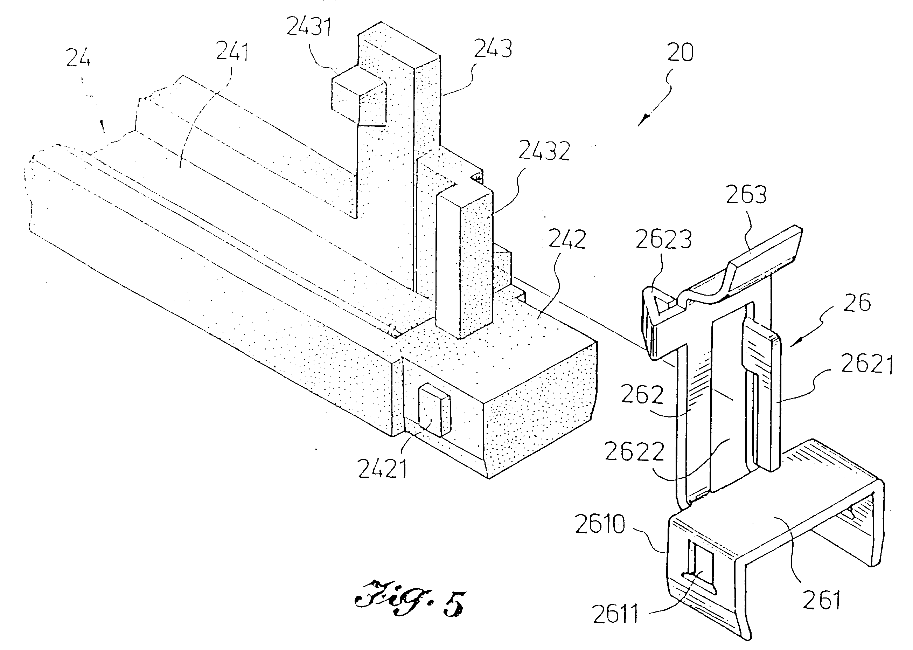

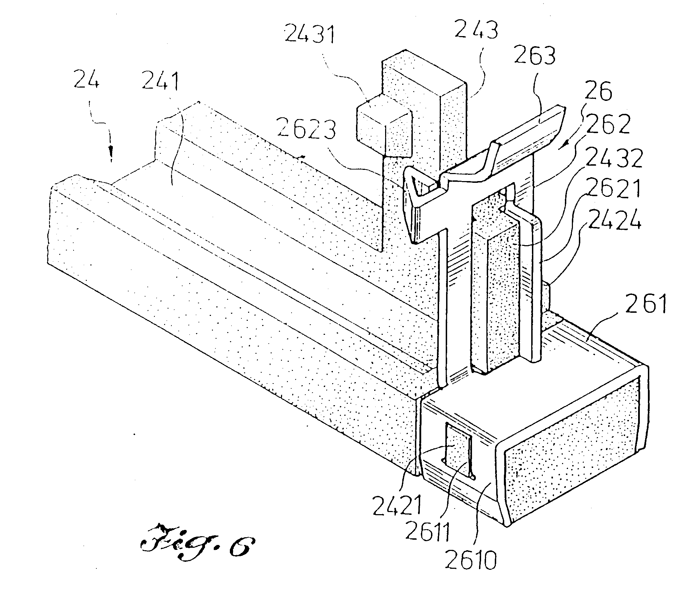

Figures 5 and 6 show a second embodiment of an electrical connector 20. The electrical connector 20 comprises an elongated housing 24 molded of an insulating resin material and two end portions 242. A groove 241 is provided longitudinally on the top surface of the housing 24 between the two end portions 242 for receiving a daughter board. A plurality of contact terminals (not shown) are arranged in the groove 241 of the housing 24 to enable electrical connection between the mother board and the daughter board.

A pair of projections forming latching members 243 made of a resin material are integrally molded with the housing 24 and uprightly located adjacent to the end portions 242 of the housing 24. The end of each latch member 243, is provided with a rib 2432 near the end portion 242. The side of each latch member 243, which is located near the groove 241 of the housing 24 is provided with a boss 2431. When the bottom edge of the daughter board is inserted into the groove 241 of the housing 24, the boss 2431 engages the corresponding daughter board's opening (not shown).

A pair of metal fasteners or latches 26 are detachably clamped onto the end portion 242 of the housing 24. Each metal fastener 26 comprises a fixing section 261 and a spring section 262 which substantially extends therefrom. The fixing section 261 has two side plates 2610. Each side plate 2610 has an opening 2611 in the center, thereby the metal fastener 26 is firmly clamped with the side plates 2610 on the end portion 242 of the housing 24. It is to be noted that a corresponding projection 2421 provided at the side of the end portion 242 of the housing 24 fits the opening 2611. Thus, the metal fastener 26 can resist the force which is exerted from varied directions and ensures stability.

The spring section 262 of the metal fastener 26 is flexible, and a restriction leg 2621 and a slot 2622 are formed by punching the spring section 262. The restricting leg 2621 is substantially vertical to the surface of the spring section 262 and has a suitable clearance with the fixing section 261 such that it regulates any excessive flexing of the spring section 262 to avoid possible overstress. When the metal fastener 26 clamps on the housing 24, the rib 2432 of the latch member 243 fits the slot 2622 to prevent the side shifting of the metal fastener 26.

A handle 263 is preferably provided on the upper end of the spring section 262, and it can be manually moved to flex the spring section 262 during attachment and detachment of the daughter board to and from the housing 24. A lug 2623 is provided on the upper end of one side edge of the spring section 262 such that it contacts the surface of the daughter board for further holding the daughter board.

The attachment and detachment operations of the daughter board to and from the electrical connector of the second embodiment are the same as that of the first embodiment. The detailed description is omitted hereinafter.

## Claims

1. An electrical connector (10, 20) for connecting together first and second circuit boards, said connector comprising:
a housing (14, 24), formed from an insulating material, said housing serving to locate the first and second circuit boards for connection and having a top surface in which there is a longitudinal groove (141, 241) for receiving the second circuit board (12) therein;
a latch member (143, 243) engageable with the second circuit board, said latch member extending from the top surface of the housing (14, 24) and being positioned near an end portion of the housing, said latch member having a rib (1432, 2432) projecting along an edge thereof;
a plurality of contact terminals (144) provided in the groove of the housing for connecting together the first and second circuit boards and
a fastener or latch (16, 26) attached to the housing adjacent to the latch member (143, 243) and including a fixing or mounting section (161, 261) and a spring section (162, 262), said fastener (16, 26) being mounted with the mounting section (161, 261) of the latch (16, 26) attached to the associated end portion of the housing and the spring section of the latch being placed in elastic contact with the adjacent latch member (143, 243) wherein the spring section (162, 262) of the latch (16, 26) is provided with a slot (1622, 2622)
characterised in that
the rib (1432, 2432) of the latch member (143, 243) extends through the slot (1622, 2622) to an extent that the rib (1432, 2432) guides the spring section (162, 262) of the fastener (16, 26) and inhibits side shifting of the fastener and rotation of the fastener.

2. An electrical connector in accordance with claim 1 and further comprising a further latch member (143, 243) positioned near another end portion of the housing and a further fastener or latch (16, 26) attached to the housing adjacent to the further latch member and associated therewith, the mounting section (161, 261) of the further fastener or latch being attached to said other end of portion of the housing.

3. An electrical connector in accordance with Claim 1 or 2, wherein the mounting section (161) of the or each fastener or latch (16) has two side plates (1610), each side plate (1610) being provided with a pair of mounting legs (1611, 1612) located at lower corners thereof, whereby the latch is fixed firmly by clamping the mounting legs in corresponding recesses or indentations (1421, 1422) provided at a side of the associated end portion of the housing.

4. An electrical connector in accordance with Claim 1 or 2, wherein the mounting section (261) of the or each fastener or latch (26) has two side plates (2610), at least one of the side plates (2610) having an opening (2611) therein and wherein the associated end portion of the housing has a corresponding projection (2421) which engages in the opening (2611).

5. An electrical connector in accordance with Claim 3, wherein the housing (14) is provided with first and second tabs (1424, 1423) at opposite sides thereof, a top edge of one of the side plate (1610) of the or each latch (16) resists against a bottom edge of the first tab (1423) and the other side plate (1610) engages with the second tab (1424).

6. An electrical connector in accordance with any one of Claims 1 to 5, wherein the or each fastener or latch (16, 26) is provided with an anti-overstress member for preventing the fastener or latch from being overstressed.

7. An electrical connector in accordance with Claim 6, wherein said anti-overstress member serves to prevent the associated fastener or latch from being overstressed during placement of the second circuit board, or during installation or removal.

8. An electrical connector in accordance with Claim 6 or 7, wherein said anti-overstress member is formed by a partially detached punched out portion of the associated fastener or latch.

9. An electrical connector in accordance with Claim 8, wherein said punched out portion corresponds to said slot of the associated fastener or latch.

10. An electrical connector in accordance with Claim 6 or 7, wherein said anti-overstress member is integral with the associated fastener or latch.

11. An electrical connector in accordance with Claim 6 or 7, wherein said anti-overstress member is of a reversed L-shaped configuration with a horizontal portion and a vertical portion, said horizontal portion being attached to the remainder of the associated fastener or latch.

12. An electrical connector in accordance with Claim 6 or 7, wherein said anti-overstress member is located near said slot of the associated fastener or latch.

13. An electrical connector in accordance with Claim 6 or 7, wherein said anti-overstress member is in the form of a restricting leg (1621, 2621) adjacent the slot (1622, 2622) of the associated fastener or latch; the leg extending in a plane substantially perpendicular to the spring section (162, 262) and being spaced from the mounting section (161, 261).

14. An electrical connector in accordance with Claim 13, wherein the restricting leg (1621, 2621) is formed along an edge of the slot (1622, 2622) of the associated fastener or latch and includes a surface for engaging a side surface of the rib (1432, 2432).

15. An electrical connector in accordance with Claim 13 or 14, wherein the or each slot (1622, 2622) and the associated restricting leg (1621, 2621) are formed by punching a portion of the spring section (161, 261) of the associated fastener or latch.

16. An electrical connector in accordance with Claim 15, wherein the restricting leg (1621, 2621) is formed from a portion of the spring section (161, 261) of the associated fastener or latch displaced to form the slot (1622, 2622).

17. An electrical connector in accordance with any one of Claims 1 to 16, wherein the or each latch member (143, 243) is provided with a boss (143, 243) at one side near the groove of the housing (14, 24) for location with the second circuit board (12).

18. An electrical connector in accordance with any one of Claims 1 to 17, wherein the spring section (162, 262) of the or each fastener or latch (16, 26) further comprises a handle (163, 263) for manually flexing the spring section (162, 262).

19. An electrical connector in accordance with any one of Claims 1 to 18, wherein the spring section (162, 262) of the or each fastener or latch (16, 26) further comprises a lug(1623, 2623) on one side edge thereof for contacting the second circuit board (12).

20. An electrical connector in accordance with any one of Claims 1 to 19, wherein the or each fastener or latch is in the form of a separable latch (16, 26) for resiliently engaging the second circuit board (12) so as to maintain the circuit board at a predetermined angle and a predetermined position with respect to the first circuit board when the second circuit board is placed in said groove (141, 241) of said connector housing.

21. An electrical connector in accordance with Claim 20, wherein the separable latch (16, 26) is located adjacently to one end of said groove, or each separable latch is located adjacently to a different end of said groove.

22. An electrical connector in accordance with any one of Claims 1 to 21, wherein the fixing or mounting section of the or each fastener or latch is in the form of an anchoring member (161, 261) located adjacent to said associated spring section for anchoring said fastener or latch to said connector housing.

23. An electrical connector in accordance with Claim 22, wherein said anchoring member (161, 261) is formed to conform to a predetermined portion of said top surface of said connector housing.

24. An electrical connector in accordance with Claim 22, wherein said anchoring member (161, 261) secures said fastener or latch to said connector housing by anchoring to at least two adjacent outer surfaces of said connector housing.

25. An electrical connector in accordance with Claim 22, wherein said anchoring member at least includes a clamping leg (1611, 1612).

26. An electrical connector in accordance with Claim 25, wherein there are several clamping legs (1611, 1612) located at a bottom of said fastener or latch.

27. An electrical connector in accordance with any one of Claims 1 to 26, wherein the or each latch member (143, 243) is integral with said connector housing (141, 241).

28. An electrical connector in accordance with any one of Claims 1 to 27, wherein the or each rib (1432, 2432) provides a projection transverse to a longitudinal axis of said groove.

29. An electrical connector in accordance with any one of Claims 1 to 28, wherein the or each said fastener or latch (16, 26) is made from resilient metal.

30. An electrical connector in accordance with any one of Claims 1 to 31, wherein the or each fastener or latch (16, 26) is capable of resiliently flexing away from the second circuit board (12) during installation and removal of the second circuit board and the or each rib (1432, 2432) extends through the said associated slot (1622, 2622) for guiding said latch or fastener during said installation and removal.

31. An electrical connector in accordance with any one of Claims 1 to 30, wherein the or each rib (1432, 2432) and the associated slot (1622, 2622) of the or each fastener or latch (16, 26) engage one another so as to prevent the or each fastener or latch (16, 26) from rotating about the axis of the groove (141, 241) whilst guiding the associated fastener or latch (16, 26) over a predetermined path.

## Patentansprüche

1. Elektrischer Steckverbinder (10, 20) zum Verbinden einer ersten Leiterplatte mit einer zweiten Leiterplatte mit folgenden Bauteilen:
ein aus einem isolierenden Material bestehendes Gehäuse (14, 24), um die erste und die zweite Leiterplatte zum Verbinden entsprechend zu plazieren, das eine Oberseite mit einer Längsnut (141, 241) zur Aufnahme der zweiten Leiterplatte (12) umfaßt;
ein mit der zweiten Leiterplatte in Eingriff bringbares Rastelement (143, 243), das sich von der Oberseite des Gehäuses (14, 24) aus erstreckt und benachbart zu einem Endteil des Gehäuses angeordnet ist, wobei das Rastelement eine entlang einer seiner Kanten vorstehende Rippe (1432, 2432) umfaßt;
mehrere in der Nut des Gehäuses angeordnete Kontaktklemmen (144) zum Verbinden der beiden Leiterplatten;
eine benachbart zu dem Rastelement (143, 243) an dem Gehäuse angebrachte Befestigungseinrichtung oder Raste (16,26) mit einem Befestigungs- oder Montageabschnitt (161, 261) und einem Federabschnitt (162, 262), wobei die Befestigungseinrichtung oder Raste (16, 26) so angebracht ist, daß der Befestigungsabschnitt (161, 261) der Raste (16, 26) an dem zugeordneten Endteil des Gehäuses angebracht ist, während der Federabschnitt der Raste (16, 26) so angeordnet ist, daß er in elastischem Kontakt mit dem benachbarten Rastelement (143, 243) steht, und wobei der Federabschnitt (162, 262) der Raste (16, 26) mit einem Schlitz (1622, 2622) versehen ist,
dadurch gekennzeichnet,
daß sich die Rippe (1432, 2432) des Rastelementes (143, 243) so weit durch den Schlitz (1622, 2622) erstreckt, daß die Rippe (1432, 2432) den Federabschnitt (162, 262) der Befestigungseinrichtung (16, 26) führt und eine seitliche Verschiebung und eine Drehung der Befestigungseinrichtung verhindert.

2. Elektrischer Steckverbinder nach Anspruch 1 mit einem benachbart zu dem anderen Endteil des Gehäuses angeordneten weiteren Rastelement (143, 243) und einer weiteren Befestigungseinrichtung oder Raste (16, 26), die benachbart zu dem weiteren Rastelement an dem Gehäuse angebracht und dem weiteren Rastelement zugeordnet ist, wobei der Montageabschnitt (161, 261) der weiteren Befestigungseinrichtung oder Raste an dem anderen Endteil des Gehäuses angebracht ist.

3. Elektrischer Steckverbinder nach Anspruch 1 oder 2, wobei der Montageabschnitt (161) der oder jeder Befestigungseinrichtung oder Raste (16) zwei Seitenplatten (1610) umfaßt, die jeweils mit einem Paar Montageschenkel (1611, 1612) versehen sind, welche an unteren Ecken der Seitenplatten (1610) angeordnet sind, und wobei die Raste durch Festklemmen der Montageschenkel in entsprechenden Aussparungen oder Vertiefungen (1421, 1422) sicher befestigt ist, die an der Seite des zugeordneten Endteils des Gehäuses angebracht sind.

4. Elektrischer Steckverbinder nach Anspruch 1 oder 2, wobei der Montageabschnitt (261) der oder jeder Befestigungseinrichtung oder Raste (26) zwei Seitenplatten (2610) umfaßt, wobei zumindest eine der Seitenplatten (2610) mit einer Öffnung (2611) versehen ist, und wobei das zugeordnete Endteil des Gehäuses einen mit der Öffnung (2611) in Eingriff stehenden zugeordneten Vorsprung (2421) umfaßt.

5. Elektrischer Steckverbinder nach Anspruch 3, wobei das Gehäuse (14) an gegenüberliegenden Seiten mit einem ersten und einem zweiten Vorsprung (1423, 1424) versehen ist, und wobei eine Oberkante einer der Seitenplatten (1610) der oder jeder Raste (16) an einer Unterkante des ersten Vorsprungs (1423) anliegt, während die andere Seitenplatte (1610) mit dem zweiten Vorsprung (1424) in Eingriff steht.

6. Elektrischer Steckverbinder nach einem der Ansprüche 1 bis 5, wobei die oder jede Befestigungseinrichtung oder Raste (16, 26) mit einem Überlastungsschutzelement versehen ist, um eine Überlastung der Befestigungseinrichtung oder Raste zu verhindern.

7. Elektrischer Steckverbinder nach Anspruch 6, wobei das Überlastungsschutzelement dazu dient, die zugeordnete Befestigungseinrichtung oder Raste beim Anordnen der zweiten Leiterplatte oder während der Installation oder Montage oder beim Ausbau vor einer Überlastung zu schützen.

8. Elektrischer Steckverbinder nach Anspruch 6 oder 7, wobei das Überlastungsschutzelement durch ein teilweise separates ausgestanztes Teil der zugeordneten Befestigungseinrichtung oder Raste gebildet wird.

9. Elektrischer Steckverbinder nach Anspruch 8, wobei das ausgestanzte Teil dem Schlitz der zugeordneten Befestigungseinrichtung oder Raste entspricht.

10. Elektrischer Steckverbinder nach Anspruch 6 oder 7, wobei das Überlastungsschutzelement einstückig mit der zugeordneten Befestigungseinrichtung oder Raste ausgebildet ist.

11. Elektrischer Steckverbinder nach Anspruch 6 oder 7, wobei das Überlastungsschutzelement die Gestalt eines auf dem Kopf stehenden L mit einem horizontalen Teil und einem vertikalen Teil aufweist, und wobei der horizontale Teil an dem restlichen Teil der zugeordneten Befestigungseinrichtung oder Raste angebracht ist.

12. Elektrischer Steckverbinder nach Anspruch 6 oder 7, wobei das Überlastungsschutzelement benachbart zu dem Schlitz der zugeordneten Befestigungseinrichtung oder Raste angeordnet ist.

13. Elektrischer Steckverbinder nach Anspruch 6 oder 7, wobei das Überlastungsschutzelement die Form eines Begrenzungsschenkels (1621, 2621) benachbart zu dem Schlitz (1622, 2622) der zugeordneten Befestigungseinrichtung oder Raste aufweist, der sich in einer im wesentlichen senkrecht zu dem Federabschnitt (162, 262) verlaufenden Ebene erstreckt und zu dem Befestigungsabschnitt (161, 261) beabstandet ist.

14. Elektrischer Steckverbinder nach Anspruch 13, wobei der Begrenzungsschenkel (1621, 2621) entlang einer Kante des Schlitzes (1622, 2622) der zugeordneten Befestigungseinrichtung oder Raste ausgebildet ist und eine Oberfläche umfaßt, die mit einer Seitenfläche der Rippe (1432, 2432) in Eingriff tritt.

15. Elektrischer Steckverbinder nach Anspruch 13 oder 14, wobei der oder jeder Schlitz (1622, 2622) und der jeweils zugeordnete Begrenzungsschenkel (1621, 2621) durch Ausstanzen eines Teils des Federabschnittes (161, 261) der zugeordneten Befestigungseinrichtung oder Raste gebildet werden.

16. Elektrischer Steckverbinder nach Anspruch 15, wobei der Begrenzungsschenkel (1621, 2621) aus einem Teil des Federabschnittes (161, 261) der zugeordneten Befestigungseinrichtung oder Raste gebildet ist, verschoben zur Bildung des Schlitzes (1622, 2622).

17. Elektrischer Steckverbinder nach einem der Ansprüche 1 bis 16, wobei das oder jedes Rastelement (143, 243) an einer Seite benachbart zu der Nute des Gehäuses (14, 24) zur Positionierung mit der zweiten Leiterplatte (12) mit einem Vorsprung (143, 243) versehen ist.

18. Elektrischer Steckverbinder nach einem der Ansprüche 1 bis 17, wobei der Federabschnitt (162, 262) der oder jeder Befestigungseinrichtung oder Raste (16, 26) zudem einen Handgriff (163, 263) zum manuellen Biegen des Federabschnittes (162, 262) umfaßt.

19. Elektrischer Steckverbinder nach einem der Ansprüche 1 bis 18, wobei der Federabschnitt (162, 262) der oder jeder Befestigungseinrichtung oder Raste (16, 26) zudem an einer Seite eine Nase (1623, 2623) für einen Kontakt mit der zweiten Leiterplatte (12) umfaßt.

20. Elektrischer Steckverbinder nach einem der Ansprüche 1 bis 19, wobei die oder jede Befestigungseinrichtung oder Raste die Form einer trennbaren Raste (16, 26) für einen elastischen Eingriff mit der zweiten Leiterplatte (12) aufweist, um die Leiterplatte unter einem vorbestimmten Winkel und in einer vorbestimmten Stellung bezüglich der ersten Leiterplatte zu halten, wenn die zweite Leiterplatte in der Nut (141, 241) des Steckverbindergehäuses angeordnet wird.

21. Elektrischer Steckverbinder nach Anspruch 20, wobei die trennbare Raste (16, 26) benachbart zu einem Ende der Nut angeordnet ist oder wobei die trennbaren Rasten jeweils benachbart zu einem anderen Ende der Nut angeordnet sind.

22. Elektrischer Steckverbinder nach einem der Ansprüche 1 bis 21, wobei der Befestigungs- oder Montageabschnitt der oder jeder Befestigungseinrichtung oder Raste die Form eines Verankerungselementes (161, 261) aufweist, das benachbart zu dem zugeordneten Federabschnitt angeordnet ist und zum Verankern der Befestigungseinrichtung oder Raste an dem Steckverbindergehäuse dient.

23. Elektrischer Steckverbinder nach Anspruch 22, wobei das Verankerungselement (161, 261) so geformt ist, daß es mit einem vorbestimmten Teil der Oberfläche des Steckverbindergehäuses übereinstimmt.

24. Elektrischer Steckverbinder nach Anspruch 22, wobei das Verankerungselement (161, 261) die Befestigungseinrichtung oder Raste durch Verankern an zumindest zwei benachbarten Außenflächen des Steckverbindergehäuses an dem Steckverbindergehäuse sichert.

25. Elektrischer Steckverbinder nach Anspruch 22, wobei das Verankerungselement zumindest einen Klemmschenkel (1611, 1612) umfaßt.

26. Elektrischer Steckverbinder nach Anspruch 25, wobei mehrere Klemmschenkel (1611, 1612) am Fußteil der Befestigungseinrichtung oder Raste angeordnet sind.

27. Elektrischer Steckverbinder nach einem der Ansprüche 1 bis 26, wobei das oder jedes Rastelement (143, 243) einstückig mit dem Steckverbindergehäuse (141, 241) ausgebildet ist.

28. Elektrischer Steckverbinder nach einem der Ansprüche 1 bis 27, wobei die oder jede Rippe (1432, 2432) einen sich quer zu der Längsachse der Nut erstreckenden Vorsprung bildet.

29. Elektrischer Steckverbinder nach einem der Ansprüche 1 bis 28, wobei die oder jede Befestigungseinrichtung oder Raste (16, 26) aus einem elastischen Material besteht.

30. Elektrischer Steckverbinder nach einem der Ansprüche 1 bis 31, wobei die oder jede Befestigungseinrichtung oder Raste (16, 26) bei der Montage und beim Ausbau der zweiten Leiterplatte (12) elastisch bezüglich der zweiten Leiterplatte (12) verbiegbar ist und wobei sich die oder jede Rippe (1432, 2432) durch den zugeordneten Schlitz (1622, 2622) erstrecken, um die Raste oder Befestigungseinrichtung bei der Montage und beim Ausbau zu führen.

31. Elektrischer Steckverbinder nach einem der Ansprüche 1 bis 30, wobei die oder jede Rippe (1432, 2432) und der zugehörige Schlitz (1622, 2622) der oder jeder Befestigungseinrichtung oder Raste (16, 26) miteinander im Eingriff stehen, um zu verhindern, daß sich die oder jede Befestigungseinrichtung oder Raste (16, 26) um die Achse der Nut (141, 241) dreht während die zugeordnete Befestigungseinrichtung oder Raste (16, 26) auf einem vorbestimmten Weg geführt wird.

## Revendications

1. Connecteur électrique (10, 20) servant à connecter des première et seconde plaquettes de circuits, ledit connecteur comprenant :
un boîtier (14, 24) constitué d'un matériau isolant, ledit boîtier servant à disposer les première et seconde plaquettes de circuits en vue d'une connexion et présentant une surface de dessus dans laquelle il existe une gorge longitudinale (141, 241) pour y recevoir la seconde plaquette de circuits (12);
un élément de blocage (143, 243) pouvant s'engager avec la seconde plaquette de circuits, ledit élément de blocage s'étendant à partir de la surface de dessus du boîtier (14, 24) et étant placé à proximité d'une partie d'extrémité du boîtier, ledit élément de blocage comportant une nervure (1432, 2432) s'avançant le long de sa bordure ,
une pluralité de bornes de contact (144) prévues dans la gorge du boîtier pour connecter ensemble les première et seconde plaquettes de circuits et
un élément de fixation ou un élément de verrouillage (16, 26) fixé au boîtier, adjacent à l'élément de blocage (143, 243) , et incluant une section de fixation ou de montage (161, 261) et une section à ressort (162, 262), ledit élément de fixation (16, 26) étant fixé à la section de montage (161, 261) de l'élément de verrouillage (16, 26) fixée à la partie d'extrémité associée du boîtier et la section à ressort de l'élément de verrouillage étant placée en contact élastique avec l'élément de blocage adjacent (143, 243), dans lequel la section à ressort (162, 262) de l'élément de verrouillage (16, 26) est dotée d'une fente (1622, 2622), caractérisé en ce que la nervure (1432, 2432) de l'élément de blocage (143, 243) s'étend à travers la fente (1622, 2622) sur une longueur telle que la nervure (1432, 2432) guide la section à ressort (162, 262) de l'élément de verrouillage (16, 26) et empêche un décalage latéral de l'élément de verrouillage et une rotation de celui-ci.

2. Connecteur électrique selon la revendication 1 et comprenant, de plus, un élément de blocage supplémentaire (143, 243) placé à proximité de l'autre partie d'extrémité du boîtier et un autre élément de fixation ou de verrouillage (16, 26) fixé au boîtier de façon adjacente à l'autre élément de blocage et associé à lui, la section de montage (1621 261) de l'élément de fixation ou de verrouillage supplémentaire étant fixée à ladite autre partie d'extrémité du boîtier.

3. Connecteur électrique selon la revendication 1 ou 2, dans lequel la section de montage (161) du ou de chaque élément de fixation ou de verrouillage (16) possède deux plaques latérales (1610), chaque plaque latérale (1610) étant dotée d'une paire de jambes de montage (1611, 1612) placées au niveau de ses coins inférieurs, de sorte que l'élément de verrouillage est fixé solidement en bloquant les jambes de montage dans des évidements correspondants ou dans des entailles correspondantes (1421, 1422) prévues au niveau d'un côté de la partie d'extrémité associée du boîtier.

4. Connecteur électrique selon la revendication 1 ou 2, dans lequel la section de montage (261) du ou de chaque élément de fixation ou de verrouillage (26) comporte deux plaques latérales (2610), une au moins des plaques latérales (2610) comportant une ouverture (2611) et dans lequel la partie d'extrémité associée du boîtier possède une partie en saillie correspondante (2421) qui s'engage dans l'ouverture (2611).

5. Connecteur électrique selon la revendication 3, dans lequel le boîtier (14) est doté de première et seconde pattes (1424, 1423) au niveau de ses côtés opposés, un bord supérieur de l'une des plaques latérales (1610) de l'élément ou de chaque élément de verrouillage (16) s'oppose au bord inférieur de la première patte (1423) et l'autre plaque latérale (1610) s'engage avec la seconde patte (1424).

6. Connecteur électrique selon l'une quelconque des revendications 1 à 5, dans lequel l'élément ou chaque élément de fixation ou de verrouillage (16, 26) est muni d'un élément de résistance à une contrainte excessive pour empêcher l'élément de fixation ou de verrouillage de subir une contrainte excessive.

7. Connecteur électrique selon la revendication 6, dans lequel ledit élément de résistance à une contrainte excessive sert à empêcher l'élément de fixation ou de verrouillage associé de subir une contrainte excessive pendant l'installation de la seconde plaquette de circuits, ou pendant l'installation ou le retrait.

8. Connecteur électrique selon la revendication 6 ou 7, dans lequel ledit élément de résistance à une contrainte excessive est formé par une partie découpée partiellement détachée de l'élément de fixation ou de verrouillage associé.

9. Connecteur électrique selon la revendication 8, dans lequel ladite partie découpée correspond à ladite fente de l'élément de fixation ou de verrouillage associé.

10. Connecteur électrique selon la revendication 6 ou 7, dans lequel ledit élément de résistance à une contrainte excessive est intégré audit élément de fixation ou de verrouillage.

11. Connecteur électrique selon la revendication 6 ou 7, dans lequel ledit élément de résistance à une contrainte excessive est configuré en forme de L inversé présentant une partie horizontale et une partie verticale, ladite partie horizontale étant fixée à la partie restante de l'élément de fixation ou de verrouillage.

12. Connecteur électrique selon la revendication 6 ou 7, dans lequel ledit élément de résistance à une contrainte excessive est placé près de ladite fente de l'élément de fixation ou de verrouillage associé.

13. Connecteur électrique selon la revendication 6 ou 7, dans lequel ledit élément de résistance à une contrainte excessive se présente sous la forme d'une jambe de limitation (1621, 2621) adjacente à la fente (1622, 2622) de l'élément de fixation ou de verrouillage assocé, la jambe s'étendant dans un plan essentiellement perpendiculaire à la section à ressort (162, 262) et étant distante de la section de fixation (161, 261).

14. Connecteur électrique selon la revendication 13, dans lequel la jambe de limitation (1621, 2621) est formée le long d'un bord de la fente (1622, 2622) de l'élément de fixation ou de verrouillage associé et comporte une surface destinée à engager une surface latérale de la nervure (1432, 2432).

15. Connecteur électrique selon la revendication 13 ou 14, dans lequel la ou chaque fente (1622, 2622) et la jambe de limitation associée (1621, 2621) sont formées en découpant une partie de la section à ressort (161, 261) de l'élément de fixation ou de verrouillage associé.

16. Connecteur électrique selon la revendication 15, dans lequel la jambe de limitation (1621, 2621) est formée à partir d'une partie de la section à ressort (161, 261) de l'élément de fixation ou de verrouillage associé déplacée pour former la fente (1622, 2622).

17. Connecteur électrique selon l'une quelconque des revendications 1 à 16, dans lequel l'élément ou chaque élément de verrouillage (143, 243) est pourvu d'un bossage (143, 243) au niveau du côté proche de la gorge du boîtier (14, 24) pour positionner la seconde plaquette de circuits (12).

18. Connecteur électrique selon l'une quelconque des revendications 1 à 17, dans lequel la section à ressort (162, 262) de l'élément ou de chaque élément fixation ou de verrouillage (16, 26) comprend, de plus, une poignée (163, 263) pour faire infléchir manuellement la section à ressort (162, 262).

19. Connecteur électrique selon l'une quelconque des revendications 1 à 18, dans lequel la section à ressort (162, 262) de l'élément ou de chaque élément de fixation ou de verrouillage (16, 26) comprend, de plus, une languette repliée (1623, 2623) sur un de ses bords latéraux pour être en contact avec la seconde plaquette de circuits (12).

20. Connecteur électrique selon l'une quelconque des revendications 1 à 19, dans lequel l'élément ou chaque élément de fixation ou de verrouillage se présente sous la forme d'un élément de blocage séparable (16, 26)pour s'engager élastiquement avec la seconde plaquette de circuits (12) de façon à maintenir la plaquette de circuits suivant un angle prédéterminé et une position prédéterminée par rapport à la première plaquette de circuits lorsque la seconde plaquette de circuits est placée dans ladite gorge (141, 241) dudit boîtier de connecteur.

21. Connecteur électrique selon la revendication 20, dans lequel l'élément de blocage séparable (16, 26) est placé de façon adjacente à la première extrémité de ladite gorge, ou chaque élément de blocage séparable est placé de façon adjacente à une extrémité différente de ladite gorge.

22. Connecteur électrique selon l'une quelconque des revendications 1 à 21, dans lequel la section de fixation ou de montage de l'élément ou de chaque élément de fixation ou de verrouillage se présente sous la forme d'un élément d'ancrage (161, 261) placé de façon adjacente à ladite section à ressort associée afin d'ancrer ledit élément de fixation ou de verrouillage sur ledit boîtier de connecteur.

23. Connecteur électrique selon la revendication 22, dans lequel ledit élément d'ancrage (161, 261) est formé pour se conformer à une partie prédéterminée de ladite surface de dessus dudit boîtier de connecteur.

24. Connecteur électrique selon la revendication 22, dans lequel ledit élément d'ancrage (161, 261) assure ledit élément de fixation ou de verrouillage sur ledit boîtier de connecteur en l'ancrant sur au moins deux surfaces externes adjacentes dudit boîtier de connecteur.

25. Connecteur électrique selon la revendication 22, dans lequel ledit élément d'ancrage comprend, au moins, une jambe de blocage (1611, 1612).

26. Connecteur électrique selon la revendication 25, dans lequel il existe plusieurs jambes de blocage (1611, 1612) placées dans la partie inférieure dudit élément de fixation ou de verrouillage.

27. Connecteur électrique selon l'une quelconque des revendications 1 à 26, dans lequel l'élément ou chaque élément de blocage (143, 243) est solidaire dudit boîtier de connecteur (141, 241).

28. Connecteur électrique selon l'une quelconque des revendications 1 à 27, dans lequel la ou chaque nervure (1432, 2432) fournit une partie en saillie transversale à un axe longitudinal de ladite gorge.

29. Connecteur électrique selon l'une quelconque des revendications 1 à 28, dans lequel ledit élément ou chaque dit élément de fixation ou de verrouillage (16, 26) est constitué d'un métal élastique.

30. Connecteur électrique selon l'une quelconque des revendications 1 à 31, dans lequel l'élément ou chaque élément de fixation ou de verrouillage (16, 26) est capable de s'infléchir élastiquement en s'éloignant de la seconde plaquette de circuits (12) pendant l'installation et le retrait de la seconde plaquette de circuits et la ou chaque nervure (1432, 2432) s'étend à travers ladite fente associée (1622, 2622) pour guider ledit élément de verrouillage ou de fixation pendant ladite installation et ledit retrait.

31. Connecteur électrique selon l'une quelconque des revendications 1 à 30, dans lequel la ou chaque nervure (1432, 2432) et la fente associée (1622, 2622) de l'élément ou de chaque élément de fixation ou de verrouillage (16, 26) coopèrent l'une avec l'autre de façon à empêcher l'élément ou chaque élément de fixation ou de verrouillage (16, 26) de tourner autour de l'axe de la gorge (141, 241) tout en guidant l'élément de fixation ou de verrouillage associé (16, 26) sur un parcours prédéterminé.
